# EUROPEAN PATENT APPLICATION

(11) **EP 2 851 940 A1**
(43) Date of publication of application: **25.03.2015**
(21) Application number: 14184928.1
(22) Date of filing: 16.09.2014
(51) Int. Cl.: H01L 21/67, H01L 21/677

(54) **Processing object transport system, and substrate inspection system**

(30) Priority: 20.09.2013 JP 2013195862
(71) Applicant: Nidec-Read Corporation, Ukyo-ku Kyoto-shi Kyoto 615-0854 (JP)
(72) Inventor: Nakagawa, Takashi, Kyoto, 615-0854 (JP); Matsukawa, Toshihide, Kyoto, 615-0854 (JP); Hikita, Osamu, Kyoto, 615-0854 (JP); Ogata, Akira, Kyoto, 615-0854 (JP); Kaida, Michio, Kyoto, 615-0854 (JP)
(74) Representative: Viering, Jentschura & Partner Patent- und Rechtsanwälte

(57) **Abstract**

A substrate inspection system (1) includes a plurality of processing units (12, 13, and 14), and each processing unit is provided with: a transport mechanism (2) configured to transport an substrate W to be inspected along a transport passage which extends substantially horizontally; a lift mechanism (5) configured to lift the substrate (W) to be inspected to a height position (P1), at a set position (P2) on the transport passage; and processors (A and B) each configured to perform a predetermined process on the substrate (W) to be inspected positioned at the height position (P1). The processing units (12, 13, and 14) are arranged such that transport passages thereof are aligned and such that the transport directions thereof are the same direction. Between two adjacent transport passages, the substrate (W) to be inspected is delivered from the transport passage on an upstream side to the transport passage on a downstream side. Another substrate (W) to be inspected which is different from the substrate (W) to be inspected can be transported under the substrate (W) to be inspected while the processing object is positioned at the retracted position, when the substrate (W) to be inspected is positioned at the height position (P1) by the lift mechanism (5) in the corresponding processing unit.

## Description

### BACKGROUND OF THE INVENTION

### 1. Field of the Invention

The present invention relates to a processing object transport system configured to transport a processing object which is an object of a predetermined process, to a processor which performs the process, and a substrate inspection system which uses the processing object transport system.

### 2. Description of the Related Art

There is known a substrate inspection apparatus configured to perform a plurality of inspections on a printed circuit board and a package substrate (e.g. refer to Patent document 1). The substrate inspection apparatus described in the Patent document 1 is provided with a plurality of inspection units such as an inspection unit configured to cool and inspect the substrate and an inspection unit configured to heat and inspect the substrate. Between the inspection units, there is also provided a transport mechanism which transports the substrate in order.

Patent document 1: Japanese Patent Application Laid-Open No. 2007-59727

In the inspection apparatus described above, however, the plurality of inspection units and a transport apparatus are integrally configured. Thus, in order to change inspection content or to change inspection throughput in a given time, it is necessary to remake the apparatus, and the change as described above is thus hardly performed, which is disadvantageous. Not only in the case of the inspection of the substrate, but also in the case of a processing apparatus which performs some process on the processing object, there is the same disadvantage if a plurality of processors are provided.

### SUMMARY OF THE INVENTION

It is therefore an object of the present invention to provide a processing object transport system in which processing content and processing capacity for the processing object are easily changed, and a substrate inspection system which uses the processing object transport system as described above.

The processing object transport system of the present invention is a processing object transport system configured to transport a processing object which is an object of a predetermined process, the processing object transport system including a plurality of processing units, each processing unit provided with: a first transport mechanism configured to transport the processing object along a transport passage which extends substantially horizontally; a transfer mechanism configured to transfer the processing object transported by the first transport mechanism, to a retracted position retracted from the transport passage, at a set position set in advance on the transport passage; and a processor configured to perform the predetermined process on the processing object positioned at the retracted position, wherein the plurality of processing units are arranged such that a plurality of transport passages of the respective processing units are aligned and such that the transport directions of the respective processing units are the same direction, between two adjacent transport passages out of the plurality of transport passages, two first transport mechanisms corresponding to the two transport passages deliver the processing object from the transport passage on an upstream side in the transport direction to the transport passage on a downstream side, and each first transport mechanism is configured to transport another processing object which is different from the processing object without interfering with the processing object while the processing object is positioned at the retracted position, when the processing object is transferred to the retracted position by the transfer mechanism in the corresponding processing unit.

According to this configuration, the processing object transport system is configured such that the plurality of processing units are aligned. Each of the processing units is provided with the processor configured to perform the predetermined process on the processing object, and the processing object is transported along the transport passage which extends substantially horizontally. The plurality of processing units are arranged such that the plurality of transport passages of the respective processing units are aligned and such that the transport directions of the respective processing units are the same direction. Between two adjacent transport passages out of the plurality of transport passages, the processing object is delivered from the transport passage on the upstream side in the transport direction to the transport passage on the downstream side. This makes it possible to transport the processing object to the processing units in order. It is thus possible to perform a plurality of processes on one processing object in the plurality of processing units, or to transport a plurality of processing objects to the plurality of processing units in order and to perform the processes in parallel. Since the transport passage of the processing object extends substantially horizontally, the height of an entrance and the height of an exit of the transport passage in each processing unit are substantially equal. Therefore, even in the case of an increase or a reduction in the number of the processing units, a change in the arrangement order of the processing units, an addition or a change in the arrangement order of a processing unit having different processing content of the processor, or the like, the following configuration is maintained; namely, the processing object is delivered from the transport passage on the upstream side in the transport direction to the transport passage on the downstream side between the adjacent processing units. It is therefore easy to change the processing content and the processing capacity for the processing object.

Moreover, preferably, the retracted position is positioned above the transport passage, and the each first transport mechanism is configured to transport another processing object which is different from the processing object under the processing object while the processing object is positioned at the retracted position, when the processing object is transferred to the retracted position by the transfer mechanism in the corresponding processing unit.

According to this configuration, in comparison with a case where the processing object is retracted to a position horizontally separated from the transport passage, the occupation area of the system is reduced so that space saving can be achieved.

Moreover, preferably, the processing object transport system further includes a transport unit comprising a second transport mechanism configured to transport the processing object substantially horizontally along a transport passage set in advance, the transport unit is disposed such that the transport passage of the transport unit is aligned with the transport passages of the respective processing units, and the second transport mechanism delivers the processing object between the transport passage corresponding to the second transport mechanism and another adjacent transport passage.

According to this configuration, the transport unit which is not provided with the processor is included in the transport passage of the processing object. According to this configuration, the transport unit can be used as a loader for receiving the processing object from the exterior to the system, as an unloader for extracting the processing object from the system, or as a buffer apparatus for adjusting a deviation of processing timing of each processing unit. Moreover, the second transport mechanism of the transport unit is configured in the same manner as in the first transport mechanism of the processing unit, and the arrangement position and the number of the transport units can be thus flexibly changed.

Moreover, preferably, the plurality of processors corresponding to the plurality of processing units include a first processor configured to perform a predetermined first process as the process and a second processor configured to perform a second process having a shorter processing time than that of the first process as the process, and the number of first processing units each of which is the processing unit comprising the first processor is greater than the number of second processing units each of which is the processing unit comprising the second processor.

According to this aspect, the number of the first processing units which perform the first process having a longer processing time is greater than the number of the second processing units which perform the second process having a shorter processing time. The process which takes a longer time can be thus performed in many processing units in parallel. As a result, a difference in the processing time between the first process and the second process is reduced as the entire system. This results in an improvement in the processing performance of the entire system.

Moreover, preferably, the first processing unit is disposed on the upstream side in the transport direction with respect to the second processing unit.

According to this aspect, when the transport of the processing object to each of the processing units is firstly started, the same number of processing objects as the number of the first processing units which are on the upstream side in the transport direction can be transported, quickly without waiting for the end of the process of each processing unit. Thus, in comparison with a case where the processing object is transported firstly to the second processing unit when the second processing units the number of which is less are on the upstream side in the transport direction, the number of the processing objects which can be firstly transported to the processing units quickly increases. This results in an improvement in the processing performance of the entire system.

Moreover, in the substrate inspection system of the present invention, the processing object in the processing object transport system described above is a substrate, and the process is inspection of the substrate.

According to this configuration, the processing object transport system described above can be applied to a substrate inspection apparatus configured to inspect the substrate.

### EFFECT OF THE INVENTION

The processing object transport system and the substrate inspection system which are configured in the above manner can easily change the processing content and the processing capacity for the processing object.

### BRIEF DESCRIPTION OF THE DRAWINGS

FIG. 1 is s an explanatory diagram illustrating one example of a configuration of a substrate inspection system in an embodiment of the present invention;
FIG. 2 is a top view illustrating a transport mechanism and a lift mechanism seen from above;
FIG. 3 is a block diagram illustrating one example of an electrical configuration of the substrate inspection system illustrated in FIG. 1;
FIG. 4 is an explanatory diagram for explaining the operation of the substrate inspection system illustrated in FIG. 1; and
FIGs. 5 are explanatory diagrams conceptually illustrating one example of arrangement order of processing units and a combination of the number of units which perform a different process.

### DETAILED DESCRIPTION OF THE PREFERRED EMBODIMENT

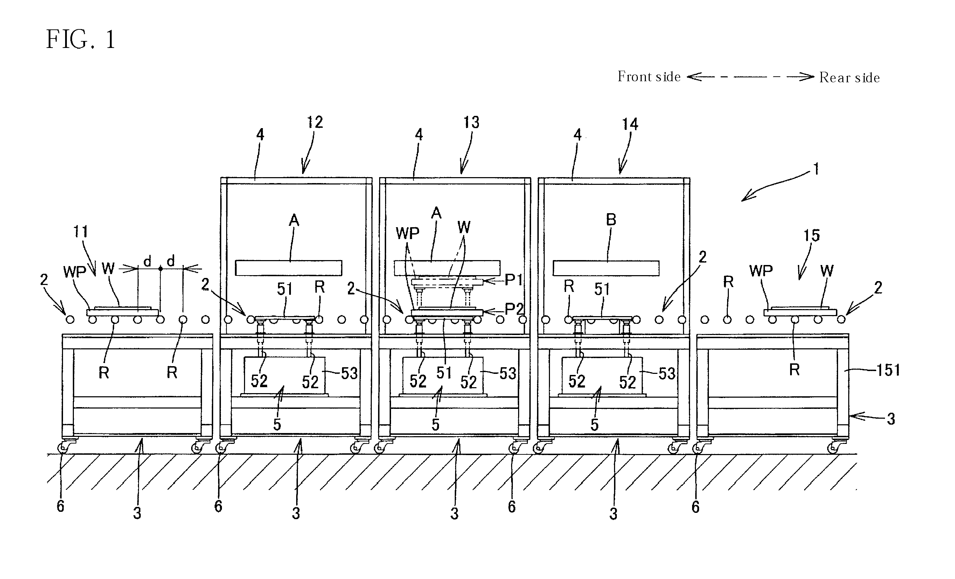

Hereinafter, an embodiment of the present invention will be explained on the basis of the drawings. A configuration which carries the same reference numeral in each drawing indicates the same configuration, and an explanation thereof is omitted. FIG. 1 is an explanatory diagram illustrating one example of a substrate inspection system in the embodiment of the present invention. A substrate inspection system 1 illustrated in FIG. 1 is provided with a loader 11, first processing units 12 and 13, a second processing unit 14, and an unloader 15. The substrate inspection system 1 corresponds to one example of the processing object transport system.

The first processing units 12 and 13 and the second processing unit 14 correspond to one example of the processing unit. The loader 11 and the unloader correspond to one example of the transport unit. For convenience of explanation, FIG. 1 describes that a left direction of FIG. 1 is the front side of the substrate inspection system 1 and that a right direction of FIG. 1 is the rear side of the substrate inspection system 1; however, the front and rear sides of the substrate inspection system 1 are not limited to the example in FIG. 1.

Each of the loader 11, the first processing units 12 and 13, the second processing unit 14 and the unloader 15 is provided with a substantially rectangular parallelepiped lower case 3 and a transport mechanism 2 disposed on top of the lower case 3. The transport mechanism 2 of each of the first processing units 12 and 13 and the second processing unit 14 corresponds to one example of the first transport mechanism. The transport mechanism 2 of each of the loader 11 and the unloader 15 corresponds to one example of the second transport mechanism.

Under the lower case 3, there are attached casters 6. This allows an operator to easily move each unit of the loader 11, the first processing units 12 and 13, the second processing unit 14, and the unloader 15. Each unit may not be provided with the casters 6.

The transport mechanism 2 transports a work plate WP substantially horizontally in a transport direction directed from the front side to the rear side. The work plate WP is a substantially rectangular plate-like member, and a substrate W to be inspected which is an inspection object is mounted on an upper surface of the work plate WP.

The upper surface of the work plate WP may be, for example, flat, or may also have, for example, a formed concave area or hollow in which the substrate W to be inspected may be accommodated. On a lower surface of the work plate WP, for example, a rubber sheet is placed. The substrate W to be inspected is, for example, a printed circuit board, a circuit board, a package substrate with a semiconductor chip mounted thereon, a glass substrate with a transparent electrode formed on a surface thereof, and the like.

The transport mechanism 2 is provided with a plurality of substantially cylindrical transport rollers R disposed at intervals of d in the transport direction, a transport motor M1 described later, a not-illustrated transport mechanism, such as a shaft and a gear, configured to transport a driving force of the transport motor M1 to the plurality of transport rollers R. Then, a transport passage on which the work plate WP is transported is formed by the plurality of transport rollers R. In other words, a line which connects upper apexes of the plurality of transport rollers R is the transport passage.

The interval d is set to be a half or less the length of the work plate WP in the transport direction, for example, 1/3 the length. This allows the plurality of transport rollers R to be always in contact with the lower surface of the work plate WP. As a result, the transport rollers R improve weight balance for supporting the work plate WP.

Moreover, the rubber sheet placed on the lower surface of the work plate WP increases friction force between the work plate WP and the transport rollers R, resulting in a reduction in sliding of the transport rollers R with respect to the work plate WP, in the transport of the work plate WP by the transport rollers R. Incidentally, the transport mechanism 2 is not only configured such that the transport rollers R are disposed at intervals of d, but may be also configured as a belt conveyer.

Each processing unit of the first processing units 12 and 13 and the second processing unit 14 is provided with an upper case 4 disposed above the lower case 3, and a lift mechanism 5 disposed below the upper case 4. Each of the first processing units 12 and 13 is provided with a first inspection unit A (or the first processor), and the second processing unit 14 is provided with a second inspection unit B (or the second processor). The first inspection unit A is accommodated in the upper case 4 of the first processing units 12 and 13. The second inspection unit B is accommodated in the upper case 4 of the second processing unit 14.

Incidentally, the loader 11 and the unloader 15 are not provided with a processor such as the first inspection unit A and the second inspection unit B.

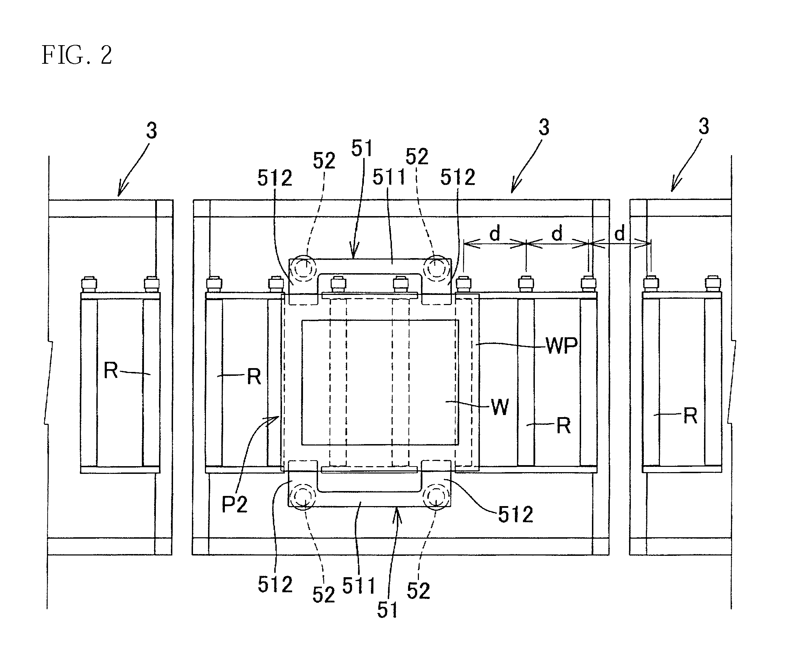

The lift mechanism 5 lifts the work plate WP transported by the transport mechanism 2 at a set position P2 set in advance on the transport passage of each unit, to a height position P1 set in advance. Specifically, the lift mechanism 5 is provided with plate holders 51, shafts 52, and a shaft driver 53. FIG. 2 is a top view illustrating the transport rollers R of the transport mechanism 2 and the lift mechanism 5 seen from above.

On both side of the transport passage on the transport rollers R, a pair of plate holders 51 is disposed. The plate holder 51 has a holder main body 511 which extends in the transport direction, and a pair of projections 512 which projects from both ends of the holder main body 511 toward the transport passage. The pair of projections 512 projects under the work plate WP positioned at the set position P2 between the two transport rollers R.

The shafts 52 extend downward from the both ends of the holder main body 511, and couple the plate holder 51 to the shaft driver 53. The shaft driver 53 vertically moves the shafts 52, thereby lifting the plate holders 51. The shaft driver 53 is made of a lift motor M2 described later, a ball screw, a gear mechanism, and the like. By this, the plate holders 51 are configured to adopt a lowered attitude so that the plate holders 51 wait for the work plate WP to be transported to the set positon P2 under the transport passage, and to adopt an elevated attitude so that the work plate WP is positioned at the height position P1. Hereinafter, a state in which the plate holders 51 have the lowered attitude, there is no work plate WP, and the plate holders 51 can receive a new work plate WP, is referred to as a standby state.

If the plate holders 51 are lifted, four projections 512 of the pair of plate holders 51 engage with the lower part of the work plate WP, and the work plate WP is lifted with the lift of the plate holders 51. The shaft driver 53 lifts and positions the plate holders 51 at the height position P1 suitable for an inspection process by the inspection unit.

While the work plate WP is positioned at the height position P1 by the plate holders 51, the transport mechanism 2 can transport another work plate WP under the aforementioned work plate WP. The lift mechanism 5 corresponds to one example of the transfer mechanism, and the height position P1 corresponds to one example of a retracted position. The retracted position is not limited to above the transport passage, and the retracted position may be set at a position separated in a direction of crossing the transport passage. The transport mechanism is not limited to a mechanism which lifts the work plate WP upward.

The first inspection unit A performs, for example, first inspection (or first process) for determining quality by measuring electrostatic capacity of a wiring pattern, with respect to the substrate W to be inspected on the work plate WP positioned at the height position P1. The second inspection unit B performs, for example, second inspection (or second process) for inspecting the presence or absence of conduction of the wiring pattern, with respect to the substrate W to be inspected on the work plate WP positioned at the height position P1. The second inspection requires a shorter inspection time than that of the first inspection, for example, half the time of the first inspection for the inspection of the substrate.

The substrate inspection system 1 is provided with the first processing units 12 and 13 having the first inspection unit A which requires a longer inspection time, and the second processing unit 14 having the second inspection unit B which requires a shorter inspection time. In other words, the number of the processing units that require a longer processing time is greater than the number of the processing unit that requires a shorter processing time.

In the case of the substrate inspection system 1, for example, there are provided the first processing units 12 and 13 which require twice the processing time of the second processing unit 14, wherein the number of the first processing units 12 and 13 is twice the number of the second processing unit 14. The processing time of the first inspection and the processing time of the second inspection are leveled in the entire substrate inspection system 1. As a substrate inspection method performed by the first inspection unit A and the second inspection unit B, there can be adopted various inspection methods.

The loader 11, the first processing units 12 and 13, the second processing unit 14, and the unloader 15 are arranged such that the transport passages of the respective units are aligned and such that the transport directions of the respective units are the same direction. Between adjacent units, two transport mechanisms 2 corresponding to two transport passages of the adjacent units are configured to deliver the work plate WP from the transport passage on the upstream side in the transport direction to the transport passage on the downstream side.

Moreover, the transport passage of each unit is substantially horizontal; namely, the height of an entrance and the height of an exit of the transport passage in each unit are substantially equal among the units. The arrangement position of each transport roller R is set such that a distance between a transport roller R at the exit of the transport passage of a unit which is on the upstream side in the transport direction out of two adjacent arbitrary units from among the units, i.e. a transport roller R positioned on the most downstream side in the transport direction in the relevant unit, and a transport roller R at the entrance of the transport passage of a unit which is on the downstream side in the transport direction, i.e. a transport roller R positioned on the most upstream side in the transport direction in the relevant unit, is less than or equal to the interval d.

As described above, the substrate inspection system 1 is formed by combining the units in which the height of the transport passage and the arrangement of the transport rollers R are set. Thus, even if the arrangement order of the units is changed or even if the number of the units is increased or reduced, the work plate WP can be smoothly delivered between the transport passages of the units. This makes it easy to change the arrangement order of the units or to increase or reduce the number of the units in the substrate inspection system 1.

It is also easy to change the processing content of the substrate inspection system 1 by forming a processing unit in which the first inspection unit A or the second inspection unit B is changed to another processor, to replace the processing unit of the substrate inspection system 1 with the processing unit having another processor, or to add the processing unit having another processor, or to perform similar actions. This makes it possible to form the substrate inspection system which facilitates the change in the processing content and the processing capacity for the substrate W to be inspected which is the processing object.

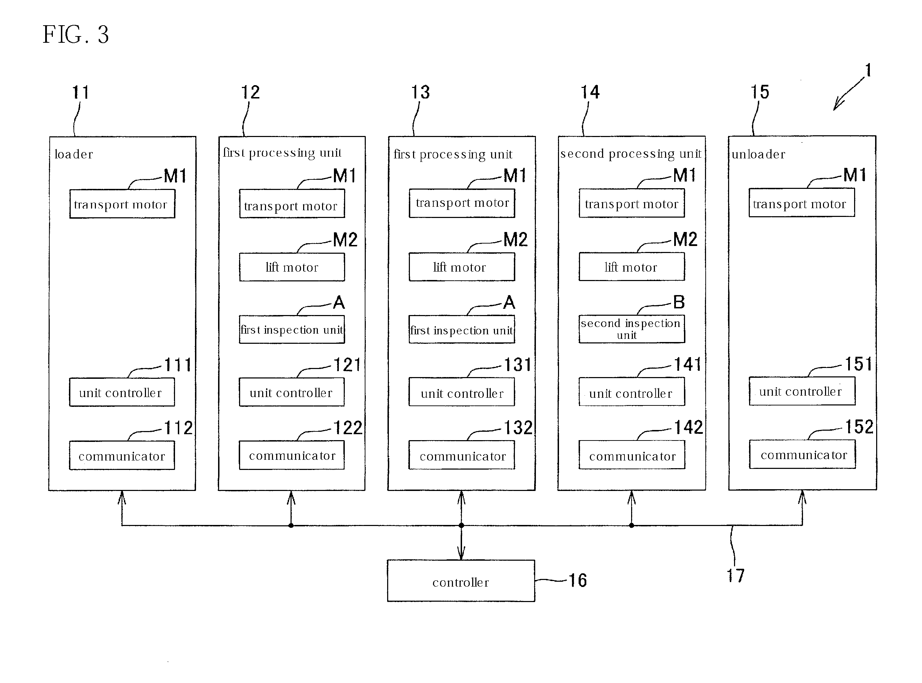

FIG. 3 is a block diagram illustrating one example of an electrical configuration of the substrate inspection system 1 illustrated in FIG. 1. The substrate inspection system 1 illustrated in FIG. 1 is provided with the loader 11, the first processing units 12 and 13, the second processing unit 14, the unloader 15, and a controller 16. The loader 11, the first processing units 12 and 13, the second processing unit 14, and the unloader 15 can transmit data to or receive the data from the controller 16 via a communication channel 17.

The loader 11 is provided with the transport motor M1, a unit controller 111, and a communicator 112. The first processing unit 12 is provided with the transport motor M1, the lift motor M2, the first inspection unit A, a unit controller 121, and a communicator 122. The first processing unit 13 is provided with the transport motor M1, the lift motor M2, the first inspection unit A, a unit controller 131, and a communicator 132. The second processing unit 14 is provided with the transport motor M1, the lift motor M2, the second inspection unit B, a unit controller 141, and a communicator 142. The unloader 15 is provided with the transport motor M1, a unit controller 151, and a communicator 152.

Each transport motor M1 rotates according to a control signal from respective one of the unit controllers 111, 121, 131, 141, and 151, and rotationally drives the transport rollers R, thereby allowing the transport mechanism 2 to rotate the work plate WP.

Each lift motor M2 reciprocally rotates according to a control signal from respective one of the unit controllers 121, 131, and 141, and applies a rotational driving force to the shaft driver 53. By this, for example, the plate holders 51 are lifted due to the positive rotation of the lift motor M2, and for example, the plate holders 51 are lowered due to the reverse rotation of the lift motor M2.

Each of the first inspection units A inspects the substrate W to be inspected on the plate holders 51 positioned at the height positon P1, according to a control signal from respective one of the unit controllers 121 and 131. The second inspection unit B inspects the substrate W to be inspected on the plate holders 51 positioned at the height positon P1, according to a control signal from the unit controller 141.

The communicators 112, 122, 132, 142, and 152 are communication interface circuits which communicate with the controller 16 via the communication channel 17. As a communication interface, various communication methods such as Ethernet (registered trademark) can be used.

The unit controllers 111, 121, 131, 141, and 151 are formed, for example, by using a microcomputer, and communicate with the controller 16 via the communicators 112, 122, 132, 142, and 152. Each of the unit controllers 111, 121, 131, 141, and 151 transmits to the controller 16, for example, information obtained by a not-illustrated sensor and information indicating the operating state of each unit, in the corresponding unit thereof. Each of the unit controllers 111, 121, 131, 141, and 151 controls the operation of the transport motor M1, the lift motor M2, the first inspection unit A, the second inspection unit B, or the like in the corresponding unit, according to a control command received from the controller 16.

The controller 16 is provided with various information processing apparatuses such as, for example, a personal computer and a programmable controller. The controller 16 receives the information transmitted from each unit of the loader 11, the first processing units 12 and 13, the second processing unit 14, and the unloader 15. The controller 16 transmits the control command to each unit, on the basis of the information transmitted from each unit. The unit controller of each unit controls the operation of each unit according to the control command.

By this, the controller 16 integrally controls the operation of the substrate inspection system 1. Hereinafter, for simplification of explanation, the operation of the unit controller of each unit which controls each unit according to the control command from the controller 16 is simply described as that the controller 16 controls each part of each unit.

Next, the operation of the substrate inspection system 1 as configured above will be explained. Firstly, as illustrated in FIG. 1, the plate holders 51 of the first processing units 12 and 13 and the second processing unit 14 have the lowered attitude, and the first processing units 12 and 13 and the second processing unit 14 are in the standby state in which the plate holders 51 can be received. If the work plate WP is mounted on the loader 11 in this state, it is detected by a not-illustrated sensor that the work plate WP is mounted on the loader 11, and the information is transmitted to the controller 16.

If it is detected that the work plate WP is mounted on the loader 11, the controller 16 drives the transport mechanisms 2 of the loader 11 and the first processing units 12 and 13, transports the work plate WP and the substrate W to be inspected to the set position P2 of the first processing unit 13 which is on the downstream side in the transport direction out of the first processing units 12 and 13, and lifts the work plate WP to the height position P1 by using the lift mechanism 5 of the first processing unit 13. If the work plate WP is positioned at the height position P1, the work plate WP is detected, for example, by a not-illustrated sensor. According to the detection signal, the first inspection unit A of the first processing unit 13 inspects the substrate W to be inspected on the work plate WP.

On the other hand, if a new work plate WP is mounted on the loader 11, the controller 16 drives the transport mechanisms 2 of the loader 11 and the first processing unit 12, transports the work plate WP and the substrate W to be inspected to the set position P2 of the first processing unit 12 which is in the standby state, and lifts the work plate WP to the height position P1 by using the lift mechanism 5 of the first processing unit 12. If the work plate WP is positioned at the height positon P1, the work plate WP is detected, for example, by a not-illustrated sensor. According to the detection signal, the first inspection unit A of the first processing unit 12 inspects the substrate W to be inspected on the work plate WP.

As described above, a plurality of substrates W to be inspected can be inspected in parallel, by the first processing units 12 and 13. Moreover, the controller 16 supplies the work plate WP to the unit, in order from the unit which is on the most downstream side in the transport direction out of the units that are in the standby state, out of the first processing units 12 and 13 which are the units that perform the first inspection on the upstream side in the transport direction, from among the units that perform the first inspection and the unit that performs the second inspection. It is thus possible to supply the work plate WP to all the first processing units 12 and 13 and start the inspection, quickly a waiting time.

If the work plate WP is supplied to the first processing unit 12 before the first processing unit 13 which is on the most downstream side in the transport direction out of the units that are in the standby state, it is hardly possible to pass a new work plate WP under the plate holders 51 and to transport it to the first processing unit 13 while the plate holders 51 of the first processing unit 12 are lifting to the set position P2. This causes a waiting time of the first processing unit 13. As a result, this likely causes a reduction in processing performance of the entire substrate inspection system 1.

Moreover, according to the substrate inspection system 1, out of the first processing units and the second processing unit which performs the second inspection, the first processing units the number of which is greater are arranged on the upstream side in the transport direction. By this, as illustrated in FIG. 1, in the first processing units the number of which is greater than the number of the second processing unit, the inspection of the substrate W to be inspected can be started, quickly without a waiting time. As opposed to this, if the second processing unit the number of which is less is arranged on the upstream side in the transport direction, the number of the substrates W to be inspected in which the inspection can be started without a waiting time becomes smaller. As a result, this likely causes the reduction in processing performance of the entire substrate inspection system 1.

Incidentally, the work plate WP is not necessarily supplied to the unit, in order from the unit which is on the most downstream side in the transport direction out of the units that are in the standby state, out of the first processing units 12 and 13 which are the units that perform the first inspection on the upstream side in the transport direction, from among the units that perform the first inspection and the unit that performs the second inspection. Out of the first processing units and the second processing unit which performs the second inspection, the first processing units the number of which is greater are not necessarily arranged on the upstream side in the transport direction.

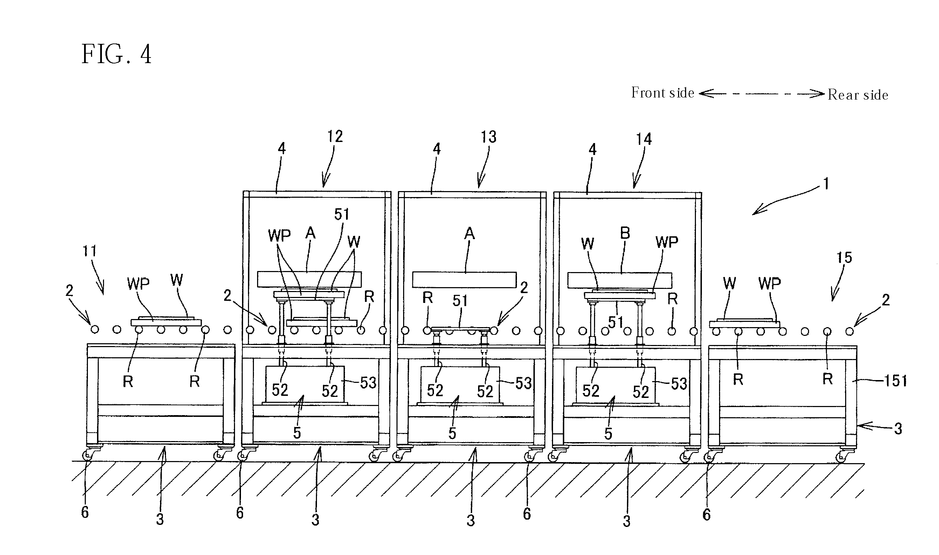

Then, if the first processing unit 13 which starts the first inspection earlier ends the first inspection before the first processing unit 12, the controller 16 lowers the plate holders 51 of the first processing unit 13 and mounts the work plate WP on the transport rollers R of the first processing unit 13, i.e. on the transport passage. The controller 16 then drives the transport mechanisms 2 of the first processing unit 13 and the second processing unit 14, and transports the work plate WP to the set position P2 of the second processing unit 14 from the first processing unit 13. The controller 16 then positions the work plate WP at the height position P1 of the second processing unit 15 by using the lift mechanism 5 of the second processing unit 14, and starts the inspection of the substrate W to be inspected on the work plate WP by the second inspection unit B (FIG. 4).

As illustrated in FIG. 4, even if the first processing unit 13 which is on the downstream side in the transport direction out of the first processing unit 12 and 13 is in the standby state and the first processing unit 12 is in the middle of the inspection, the work plate WP of the first processing unit 12 is positioned at the height position P1 and a new work plate WP can be passed under the aforementioned work plate WP. As a result, as illustrated in FIG. 4, the controller 16 passes the new work plate WP under the work plate WP which is being processed in the first processing unit 12 and can supply the new work plate WP to the fist processing unit 13 which is in the standby state by using the transport mechanisms 2 of the first processing units 12 and 13. It is thus possible to efficiently operate the plurality of first processing units.

Moreover, the lift mechanism 5 moves the work plate WP upward above the transport passage, and the inspection is performed by the inspection unit above the transport passage. Thus, a projected area on a floor of the first processing units 12 and 13 and the second processing unit 14 is smaller than that in a case where the work plate WP is moved to the side of the transport passage to perform the inspection. As a result, space saving can be achieved.

Then, if the second inspection is ended on the second processing unit 14, the controller 16 lowers the plate holders 51 of the second processing unit 14, and mounts the work plate WP on the transport rollers R of the second processing unit 14, i.e. on the transport passage. Then, the controller 16 drives the transport mechanisms 2 of the second processing unit 14 and the unloader 15, and transports the work plate WP from the second processing unit 14 to the unloader 15. By this, the work plate WP on which the already inspected substrate W is mounted is transported to the unloader 15, and the substrate W to be inspected and the work plate WP can be picked up by the operator.

It is exemplified that the substrate inspection system 1 has two first processing units and one second processing unit; however, the number of each type of units is not limited to the number exemplified above. In the substrate inspection system 1, an execution unit which executes each inspection process is unitized. Thus, the number of the units and the processing content can be flexibly changed. For example, there may be provided a plurality of first processing units and a plurality of second processing units, such as five first processing units and two second processing units.

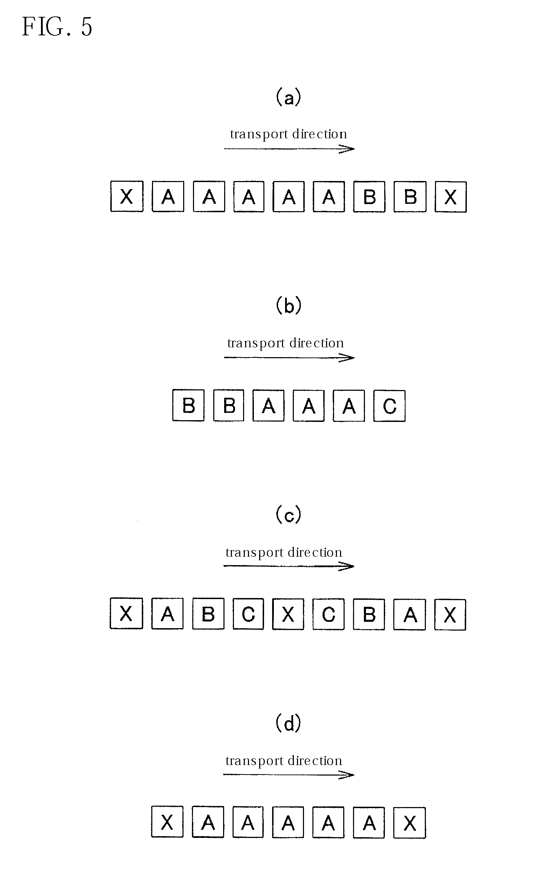

FIGs. 5 are explanatory diagrams conceptually illustrating one example of the arrangement order of the processing units and the combination of the number of units which perform a different process. In FIGs. 5, "A" indicates the first processing unit, "B" indicates the second processing unit", "C" indicates the processing unit which performs different processing from the first and second processing, and "X" indicates the transport unit.

For example, as illustrated in FIG. 5(a), the substrate inspection system 1 may be configured such that a transport unit "X", five first processing units "A", two second processing unit "B", and a transport unit "X" are arranged in this order. Alternatively, for example, as illustrated in FIG. 5(b), the substrate inspection system 1 may be configured such that two second processing units "B", three first processing units "A" and one processing unit "C" are arranged in this order. For example, as illustrated in FIG. 5(c), the substrate inspection system 1 may be configured such that a transport unit "X", a first processing units "A", a second processing unit "B", a processing unit "C", a transport unit "X", a processing unit "C", a second processing unit "B", a first processing unit "A", and a transport unit "X" are arranged in this order. For example, five first processing units "A" may be arranged between a pair of transport units "X". If processes are to be performed in a particular order due to the nature of the processes, the arrangement order of the respective processing units are determined in view of the order relation.

Moreover, it is exemplified that the substrate inspection system 1 includes the first processing units and the second processing unit which perform different types of processes; however, all the processing units included in the substrate inspection system 1 may be the unit that performs the same process.

It is also exemplified that the processing object is the substrate; however, the processing object is not limited to the substrate. It is also exemplified that the process by the processing unit is the inspection; however, the process is not limited to the inspection. For example, it can be applied to various processes such as processing, assembly, painting, printing, heating, and cooling. If the processing object is an object other than the substrate or if the processing is not different from the inspection, the substrate inspection system 1 is the processing object transport system.

It is exemplified that the substrate W to be inspected which is one example of the processing object is transported on the transport passage in the state of being mounted on the work plate WP; however, the processing object may be transported directly on the transport passage without using the work plate WP.

The substrate inspection system 1 may not be provided with the loader 11 and the unloader 15; namely, the substrate inspection system 1 may not be provided with the transport unit.

Moreover, the loader 11 and the unloader 15 are illustrated as one example of the transport unit; however, a transport unit which is configured in the same manner as in the loader 11 but is not provided with the processor may be disposed between the processing unit and the processing unit (e.g. refer to FIG. 5(c)). For example, the transport unit may be disposed between the first processing unit 13 and the second processing unit 14 illustrated in FIG. 4. If the substrate W to be inspected in which the inspection is ended on the first processing unit 13 and the work plate WP remain on the plate holders 51 of the first processing unit 13 in the state illustrated in FIG. 4, the second processing unit 14 cannot receive a new work plate WP because it is still in the middle of the inspection. Since the work plate WP of the first processing unit 13 cannot be transported to the second processing unit 14, the first processing unit 13 cannot receive and inspect the new work plate WP even though the inspection is ended.

However, for example, if the transport unit is disposed between the first processing unit 13 and the second processing unit 14 illustrated in FIG. 4, it is possible to inspect the new work plate WP on the first processing unit 13 by retracting the work plate WP on the plate holders 51 of the first processing unit 13, into the transport unit. As a result, it is possible to reduce the waiting time of the processing unit and to improve the processing performance of the entire substrate inspection system 1.

Moreover, according to the substrate inspection system 1, it is easy to change and increase or reduce the units as described above. It is thus possible to improve the processing performance of the entire substrate inspection system 1 by providing the transport unit as occasion demands.

It is also exemplified that one processing object (or substrate W to be inspected) is mounted on the work plate WP; however, a plurality of processing objects may be mounted on the work plate WP. Moreover, a plurality of work plates WP having different number or types of processing objects mounted thereon may be mixed in the processing object transport system (or the substrate inspection system 1). In this case, a recording device such as, for example, a radio frequency identification (RFID) tag and a bar code on which identification information for identifying each work plate WP may be attached to the work plate WP, each unit may be provided with a reading apparatus for the recording device, and the identification information read in each unit may be transmitted from each unit to the controller 16. Then, management information, such as the number and types of the processing objects corresponding to each piece of identification information, or a processing state (e.g. whether or not the first and second processes are ended), may be managed on the controller 16, and a process according to the management information may be performed on the unit that reads the identification information.

The unit controllers 111, 121, 131, 141 and 151 do not necessarily control the respective units according to the control command from the controller 16. The unit controllers 111, 121, 131, 141 and 151 may control the operation of the respective units as autonomously as possible. The processing content may be shared by the controller 16 and the unit controllers 111, 121, 131, 141 and 151, as occasion demands.

### Description of Reference Numerals and Letters

- 1: substrate inspection system (or processing object transport system)
- 2: transport mechanism
- 3: lower case
- 4: upper case
- 5: lift mechanism
- 6: caster
- 11: loader
- 12, 13: first processing unit
- 14: second processing unit
- 15: unloader
- 16: controller
- 17: communication channel
- 51: plate holder
- 52: shaft
- 53: shaft driver
- 111, 121, 131, 141, 151: unit controller
- 112, 122, 132, 142, 152: communicator
- 511: holder main body
- 512: projection
- A: first inspection unit
- B: second inspection unit
- M1: transport motor
- M2: lift motor
- P1: height position
- P2: set position
- R: transport roller
- W: substrate to be inspected
- WP: work plate

## Claims

1. A processing object transport system (1) configured to transport a processing object which is an object of a predetermined process, said processing object transport system (1) including a plurality of processing units (12, 13, 14), each processing unit (12, 13, 14) comprising:
a first transport mechanism (2) configured to transport the processing object along a transport passage which extends substantially horizontally;
a transfer mechanism configured to transfer the processing object transported by the first transport mechanism (2), to a retracted position retracted from the transport passage, at a set position set in advance on the transport passage; and
a processor configured to perform the predetermined process on the processing object positioned at the retracted position, wherein
the plurality of processing units (12, 13, 14) are arranged such that a plurality of transport passages of the respective processing units (12, 13, 14) are aligned and such that the transport directions of the respective processing units (12, 13, 14) are the same direction,
between two adjacent transport passages out of the plurality of transport passages, two first transport mechanisms (2) corresponding to the two transport passages deliver the processing object from the transport passage on an upstream side in the transport direction to the transport passage on a downstream side, and
each first transport mechanism (2) is configured to transport another processing object which is different from the processing object without interfering with the processing object while the processing object is positioned at the retracted position, when the processing object is transferred to the retracted position by the transfer mechanism in the corresponding processing unit (12, 13, 14).

2. The processing object transport system (1) according to claim 1, wherein
the retracted position is positioned above the transport passage, and
the each first transport mechanism (2) is configured to transport another processing object which is different from the processing object under the processing object while the processing object is positioned at the retracted position, when the processing object is transferred to the retracted position by the transfer mechanism in the corresponding processing unit (12, 13, 14).

3. The processing object transport system (1) according to claim 1 or 2, wherein
said processing object transport system (1) further includes a transport unit comprising a second transport mechanism (2) configured to transport the processing object substantially horizontally along a transport passage set in advance,
the transport unit is disposed such that the transport passage of the transport unit is aligned with the transport passages of the respective processing units (12, 13, 14), and
the second transport mechanism (2) delivers the processing object between the transport passage corresponding to the second transport mechanism (2) and another adjacent transport passage.

4. The processing object transport system according to any one of claims 1 to 3, wherein
the plurality of processors corresponding to the plurality of processing units (12, 13, 14) include a first processor configured to perform a predetermined first process as the process and a second processor configured to perform a second process having a shorter processing time than that of the first process as the process, and
the number of first processing units (12, 13) each of which is the processing unit comprising the first processor is greater than the number of second processing units (14) each of which is the processing unit comprising the second processor.

5. The processing object transport system according to any one of claims 1 to 4, wherein the first processing unit (12, 13) is disposed on the upstream side in the transport direction with respect to the second processing unit (14).

6. A substrate inspection system, wherein
the processing object in said processing object transport system according to any one of claims 1 to 5 is a substrate (W), and the process is inspection of the substrate (W).
